(19) Europäisches Patentamt
European Patent Office
Office européen des brevets

(11) EP 3 730 638 B1

(12) EUROPEAN PATENT SPECIFICATION

(45) Date of publication and mention of the grant of the patent:
**14.08.2024 Bulletin 2024/33**

(21) Application number: **18890597.0**

(22) Date of filing: **01.11.2018**

(51) International Patent Classification (IPC):
***B22F 7/06*** *(2006.01)* ***B22F 1/054*** *(2022.01)*
***B22F 1/0545*** *(2022.01)*

(52) Cooperative Patent Classification (CPC):
(C-Sets available)
**B22F 7/064; B22F 1/054; B22F 1/0545;**
B22F 1/056; B22F 1/102; B22F 2998/10;
B22F 2999/00 (Cont.)

(86) International application number:
**PCT/JP2018/040673**

(87) International publication number:
**WO 2019/123856 (27.06.2019 Gazette 2019/26)**

(54) **A SINTERED BODY**
EIN SINTERKÖRPER
UN CORPS FRITTÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **18.12.2017 JP 2017241762**

(43) Date of publication of application:
**28.10.2020 Bulletin 2020/44**

(73) Proprietor: **DIC Corporation**
**Tokyo 174-8520 (JP)**

(72) Inventors:
- **NAGATA, Hirohito**
  **Sakura-shi, Chiba 285-8668 (JP)**
- **SANO, Yoshiyuki**
  **Sakura-shi, Chiba 285-8668 (JP)**

(74) Representative: **Kraus & Lederer PartGmbB**
**Thomas-Wimmer-Ring 15**
**80539 München (DE)**

(56) References cited:
**WO-A1-2017/188123**
**JP-A- 2008 244 242**
**JP-A- 2013 084 657**
**JP-A- 2014 167 145**
**JP-A- 2015 004 122**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 730 638 B1

(52) Cooperative Patent Classification (CPC): (Cont.)

C-Sets
B22F 2998/10, B22F 9/24, B22F 1/102, B22F 3/10, B22F 7/064;
B22F 2999/00, B22F 3/10, B22F 2201/01, B22F 2201/013, B22F 2201/10, B22F 2201/11, B22F 2201/02

## Description

[Technical Field]

The present invention relates to a sintered body which can be used as a bonding element for bonding a semiconductor device component.

[Background Art]

From the viewpoint of environmental protection, regulation in use of harmful substances is widely imposed in the industry, but particularly for a mounting material, causing a solder material to be lead-free has been strongly promoted based on enforcement of the RoHS directive of the European Union. As a result, a tin-silver-copper-based solder is found and has been widely used (melting point of 217°C) as a bonding material which replaces a tin-lead eutectic solder (melting point of 183°C) in the related art. However, for mounting which requires heat resistance and heat transfer properties, for example, for an application such as bonding of a SiC chip for controlling a high current to a heat dissipation base, reliability under a high-temperature condition of 200°C or higher is required, but a bonding material having a performance alternative to a tin-lead solder has not been found, and in reality, a solder (melting point of 310°C) containing a high content (90%) of lead is still used. A bonding technique using metal fine particles is expected as a bonding method in which lead is not used and heat resistance is high. Since metal fine particles have a remarkably large specific surface area per weight compared to a bulk metal, the particles have a strong tendency to reduce surface energy due to mutual fusion, and the particles are fused to each other at a much lower temperature compared to the bulk metal. Since application of the metal fine particles as a bonding material is a lead-free bonding technique, in particular, from the viewpoint of cost and migration resistance, an investigation on a bonding method using copper fine particles or practical use of a bonding element is being conducted.

Here, a SiC chip for a vehicle is required to have a large area, but SiC and copper used for a heat dissipation base have significantly different linear expansion coefficients (for SiC, 3.7 ppm and for copper, 16.8 ppm), and thus high stress is generated in a bonding layer under an operation at a high temperature such as 200°C or higher. This stress increases as a chip size increases, and as the number of operation cycles increases, crack generation inside the bonding layer, breakage of the chip, or the like is caused, which leads to malfunction.

Various investigations have been conducted to relax the stress caused by such a difference in linear expansion coefficients. When a metal-made element is bonded to a ceramic-made element at a high temperature by using a brazing material, a crack due to thermal stress is generated near a bonding interface. In order to reduce this thermal stress, addition of fine particles into the brazing material has been investigated (for example, PTL 1). However, unlike a brazing material which causes melting, a metal nanoparticle bonding material forms a nanoparticle interface after calcination, and thus this method does not provide sufficient stress relaxation for a power device application or the like which has been recently demanded.

In addition, a heat-bonding sheet obtained by combining metal fine particles with a resin has also been reported (for example, PTL 2). Since this sheet has an elastic modulus after heat-curing of 1.5 to 10 GPa and exhibits appropriate flexibility, the reliability of the obtained sintered layer is improved. However, since a large pressure of 10 MPa or more is required at the time of bonding, it is difficult to use existing facilities.

Furthermore, regarding a metal fine particle bonding material, stress relaxation utilizing a creep behavior of a silver fine particle sintered body has also been reported (for example, PTL 3). However, since silver has problems of cost and migration resistance, a new material to replace silver is required. Furthermore, a sintered body for bonding a semiconductor device is described in WO 2017/188123 A1, JP 2014-167145 A, and JP 2008-244242 A, respectively.

As described above, the bonding technique using copper fine particles is expected to be useful, but the stress due to the difference in linear expansion coefficients between a SiC chip and a copper substrate is an obstacle to practical use.

[Citation List]

[Patent Literature]

[Patent Literature 1]
JP 2001-122673 A
[Patent Literature 2]
JP 2017-69560 A

[Patent Literature 3]
WO 2013/133085 A

[Summary of Invention]

[Technical Problem]

As described above, in the bonding of the semiconductor device component, a bonding element which can be used under a high-temperature condition of 200°C or higher is desired, but a solder with a high content of lead, which has been used so far, has a problem of environmental hazards. Moreover, a bonding element using silver fine particles has problems of high cost and migration resistance. In such circumstances, in a case where the copper fine particles can be used as a bonding element, this can be an effective method in practical use.

An object to be achieved by the present invention is to provide a bonding element in which copper fine particles are used as a bonding element of a semiconductor device component and a crack, peeling, or the like is not caused in a semiconductor device during an operation under a high-temperature condition of 200°C or higher.

[Solution to Problem]

As a result of thorough investigations, the present inventors have surprisingly found that in the sintered body of the present invention, a Vickers hardness in a high-temperature state is significantly decreased. Moreover, it has been found for the first time that a characteristic of decreasing the Vickers hardness in the high-temperature state imparts high reliability when the sintered body is used as the bonding element of the semiconductor device component. The present inventors have further investigated based on this knowledge which was not known in the related art, and as a result, have found that by using the sintered body of the present invention exhibiting such a behavior of decreasing the Vickers hardness as a bonding site of a semiconductor device, stress of the semiconductor device can be relaxed.

That is, the present invention relates to a sintered body for bonding a semiconductor device component as defined in claim 1.

[Advantageous Effects of Invention]

The present invention is a sintered body for bonding a semiconductor device component, and due to a characteristic in which a Vickers hardness is significantly decreased in a high-temperature state and the Vickers hardness returns to an original value at normal temperature (25°C), stress caused inside a semiconductor device can be relaxed. Therefore, even when the semiconductor device is exposed to a great cold-thermal shock from a low temperature to a high temperature or from a high temperature to a low temperature, a load on the bonding element can be reduced.

Accordingly, regarding a semiconductor chip, such as a MOSFET and an IGBT, in which an operation at a high temperature and increase in current density are advanced in the future, by relaxing stress caused by a difference in thermal expansion coefficients from a support, a crack or the like caused in the semiconductor device can be suppressed.

Next, an embodiment of the present invention will be described in detail.

[Description of Embodiments]

<Copper fine particle sintered body>

In a sintered body of the present invention, when a Vickers hardness of the copper fine particle sintered body at 150°C is set as Hvb and a Vickers hardness of the same copper fine particle sintered body at 25°C is set as Hva, a value of (Hvb/Hva) $\times$ 100 (%) is 5% or more and 20% or less.

For simple expression, such a feature is also paraphrased as "decreasing rate of the Vickers hardness is 5% or more and 20% or less", and in the present specification, there is a part in which the feature is expressed by the term "decreasing rate of the Vickers hardness". Moreover, for the detail of the "decreasing rate of the Vickers hardness" and the detail of a measurement method for the "Vickers hardness", refer to the description given later.

Regarding the "decreasing rate of the Vickers hardness" of the sintered body of the present invention, from the viewpoint that the effects of the present invention as described above are easily obtained, it is preferable that a Vickers hardness at 150°C is 7% or more and 10% or less of a Vickers hardness at 25°C.

Such a sintered body of the present invention is obtained according to claim 1 as a sintered body by fusing copper fine particles having a particle diameter of 1 to 300 nm by a sintering treatment at 200°C to 350°C, and the copper fine particle sintered body as a bonding element satisfies the above relationship between the Vickers hardness at 150°C and the Vickers hardness at 25°C, which is the feature of the present invention.

A calcination treatment may be performed under an inert atmosphere such as nitrogen or argon, but calcination can also be performed under a reducing atmosphere such as hydrogen or formic acid, or using an apparatus such as a plasma or light calcination.

In addition, as long as the Vickers hardness of the sintered body is within the above range, copper having different particle diameters, for example, submicron copper or micron copper can also be added.

In order to provide the sintered body having high reliability of the present invention, evaluation of the Vickers hardness of the sintered body and the presence or absence of a crack or peeling by a cold-thermal shock test is necessary. Therefore, in the present specification, the Vickers hardness of the copper fine particle sintered body after calcination was evaluated by an indentation test. Moreover, bonding reliability between the semiconductor chip and the support was evaluated by the cold-thermal shock test.

<Copper fine particle>

As the copper fine particles used in the production of the sintered body of the present invention, copper fine particles having a primary particle diameter of 1 to 300 nm are used from the viewpoint that copper fine particles are fused to each other by sintering at 200°C to 350°C, and copper fine particles having a primary particle diameter of 10 to 100 nm are preferable from the viewpoint of oxidation resistance and dispersibility. The type or the presence or absence of a surface-coated organic substance (dispersion stabilizer) of the copper fine particles is not particularly limited.

The purity of copper constituting the copper fine particle is not particularly limited and can be appropriately selected according to the purpose. The purity of the copper fine particle may be 95% by mass or more and is preferably 97% by mass or more. Moreover, a total content ratio of an organic substance, a copper oxide, and a copper hydroxide contained in the copper fine particle may be 5% or less and is preferably 3% or less. Furthermore, in the present invention, the copper oxide includes copper(II) oxide and cuprous oxide.

The shape of the copper particle is not particularly limited and can be appropriately selected, but examples thereof include a spherical shape, a plate shape, and a rod shape, and among them, a spherical shape is preferable.

<Surface-coated organic substance of copper fine particle>

As the surface-coated organic substance of the copper fine particle used in the production of the sintered body of the present invention, any dispersion stabilizer which is known and commonly used can be used, and for example, aliphatic carboxylic acids, aliphatic amines, aliphatic thiols, aliphatic thioethers, ethylene glycol, polyvinylpyrrolidone, polyethyleneimine, a polymer having a thioether structure, an oligomer having a thioether structure, a mixture thereof, and a copolymer thereof can be used.

<Organic compound (A) containing polyethylene oxide>

In order to obtain the sintered body of the present invention, copper fine particles composited with an organic compound containing polyethylene oxide having 8 to 200 carbon atoms are used. Such an organic compound can be synthesized by the method described in Japanese Patent No. 4784847, JP-A-2013-60637, or Japanese Patent No. 5077728. In these organic compounds, a thioether-type (R-S-R') compound has an appropriate affinity adsorption effect on a surface of a copper particle and rapid release properties by heating, and is developed as a metal nanoparticle exhibiting low-temperature fusion characteristics.

According to the invention, thioether-type organic compounds represented by General Formulae (1) to (3) are used.

<Thioether-type (R-S-R') organic compound>

In the present invention, a copper fine particle composited with the thioether-type organic compound represented by any of General Formulae (1) to (3).

$$W\text{-}(OCH_2CH_2)_n\text{-}O\text{-}CH_2\text{-}CH(OH)\text{-}CH_2\text{-}S\text{-}X \qquad (1)$$

$$[W\text{-}(OCH_2CH_2)_n\text{-}O\text{-}CH_2\text{-}CH(OH)\text{-}CH_2\text{-}S\text{-}]_dY \qquad (2)$$

$$[W\text{-}(OCH_2CH_2)_n\text{-}O\text{-}CH_2\text{-}CH(OH)\text{-}CH_2\text{-}S\text{-}R^a\text{-}]_tZ \qquad (3)$$

[W in Formulae (1), (2), and (3) is a $C_1$-$C_8$ alkyl group, n is an integer representing the repeating number of 4 to 100, X is a $C_2$-$C_{12}$ alkyl group, an allyl group, an aryl group, an arylalkyl group, $-R^1\text{-}OH$, $-R^1\text{-}NHR^2$, or $-R^1\text{-}(COR^3)_m$

(where $R^1$ is a $C_1$-$C_4$ saturated hydrocarbon group, $R^2$ is a hydrogen atom, a $C_2$-$C_4$ acyl group, a $C_2$-$C_4$ alkoxycarbonyl group, or a benzyloxycarbonyl group which may have a $C_1$-$C_4$ alkyl group or a $C_1$-$C_8$ alkoxy group as a substituent on an aromatic ring, $R^3$ is a hydroxy group, a $C_1$-$C_4$ alkyl group, or a $C_1$-$C_8$ alkoxy group, and m is an integer of 1 to 3), Y is a divalent to tetravalent group in which a carbon atom is directly bonded to a sulfur atom, and is a $C_1$-$C_4$ saturated hydrocarbon group or a group in which two or three $C_1$-$C_4$ saturated hydrocarbon groups are linked by -O-, -S-, or -$NHR^b$- ($R^b$ is a $C_1$-$C_4$ saturated hydrocarbon group), d is an integer of 2 to 4, $R^a$ is a $C_2$-$C_5$ alkylcarbonyloxy group, Z is a divalent to hexavalent group in which a carbon atom is directly bonded to a sulfur atom, and is a $C_2$-$C_6$ saturated hydrocarbon group, a group in which two or three $C_2$-$C_6$ saturated hydrocarbon groups are linked by -O-, -S-, or -$NHR^c$- ($R^c$ is a $C_1$-$C_4$ saturated hydrocarbon group), or an isocyanuric acid-N,N',N"-triethylene group, and t is an integer of 2 to 6.]

A chain-like functional group having ethylene oxide as a repeating unit in General Formulae (1) to (3) functions as a solvent affinity part. As the polyethylene oxide, polyethylene oxide having 8 to 200 carbon atoms is used and it is preferable that polyethylene oxide having 8 to 100 carbon atoms is used. Moreover, as the number of carbon atom in the chain-like functional group having ethylene oxide as a repeating unit in General Formulae (1) to (3) is smaller, an organic component is less likely to remain. Therefore, a chain-like functional group having about 8 to 12 carbon atoms is more preferable as a bonding element having high conductivity or reliability.

On the other hand, as the chain-like functional group having ethylene oxide as a repeating unit in General Formulae (1) to (3), a chain-like functional group having about 50 to 100 carbon atoms is more preferable since the functional group is excellent in dispersion stability and highly disperses copper fine particles and thus reproducibility and dispersibility when used as a bonding material paste are improved.

Therefore, the number of carbon atoms is appropriately adjusted within 8 to 200 or more preferably within 8 to 100, according to a use situation.

W in General Formulae (1) to (3) is a linear or branched alkyl group having 1 to 8 carbon atoms from the viewpoint of industrial availability and dispersion stability when used as a dispersant, and is preferably an alkyl group having 1 to 4 carbon atoms particularly from the viewpoint of stability in an aqueous medium.

It is preferable that X in General Formula (1) has a structure including a carboxyl group, an alkoxycarbonyl group, a carbonyl group, an amino group, or an amide group as a partial structure since formation of a polydentate ligand together with a thioether group is possible and thus a coordination force to a surface of a metal nanoparticle becomes strong.

It is most suitable that Y in General Formula (2) has a structure including ether (C-O-C) or thioether (C-S-C) as a partial structure, $R^a$ in General Formula (3) is a methylenecarboxy group ($-CH_2COO-$) or an ethylenecarboxy group ($-CH_2CH_2COO-$), and Z is an ethylene group, a 2-ethyl-2-methylenepropane-1,3-diyl group, or a 2,2-bismethylenepropane-1,3-diyl group.

<Method for producing thioether-type organic compound>

As described above, the thioether-type organic compound in the present invention is preferably a compound represented by any of General Formulae (1) to (3). A method for producing the thioether-type organic compound will be described in detail below.

As the method for simply producing the thioether-type organic compound, for example, a method of reacting a polyether compound (a1) having a glycidyl group at a terminal with a thiol compound (a2) is mentioned.

The polyether compound (a1) having a glycidyl group at a terminal can be represented by General Formula (4).

[Chem. 1]

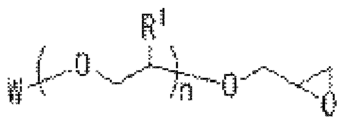

···· (4)

(In the formula, W, $R^1$, and n are the same as above.)

Examples of a method for synthesizing the polyether compound (a1) having a glycidyl group at a terminal include a method in which polyethylene glycol monoalkyl ether is added to an oxirane ring of epichlorohydrin for ring opening in the presence of a Lewis acid and then the produced chlorohydrin form is heated and re-cyclized in concentrated alkali, and a method in which a reaction is performed in one stage using a strong base such as excess alcoholate and concentrated alkali, but as a method for obtaining the polyether compound (a1) having a higher purity, a method (Gandour, et al., J. Org. Chem., 1983, 48, 1116.) of Gandour et al., in which polyethylene glycol monomethyl ether is converted to alkoxide using potassium t-butoxide, the alkoxide and epichlorohydrin are condensed, and then the resultant is continuously heated to re-form an epoxy ring, is preferably applied.

By ring-opening a terminal oxirane ring of the polyether compound (a1) having a glycidyl group at a terminal with the thiol compound (a2), a target thioether-type organic compound can be obtained. This reaction utilizes a nucleophilic reaction of a thiol group, but various activation methods can be mentioned for this reaction.

For example, synthesis by activation of epoxide with a Lewis acid is widely performed, and specifically, using zinc tartrate or a lanthanide-based Lewis acid is known. Moreover, a method using a Lewis base is also often carried out.

Furthermore, a method of utilizing a fluorine ion as a base catalyst is described in the review article of James H. Clark. Penso et al. apply this method as a ring-opening method for epoxide having excellent regioselectivity, and report that an addition and ring-opening reaction of thiol to epoxide proceeds under mild conditions by using quaternary ammonium fluoride as a catalyst.

In particular, from the viewpoint that the thioether-type organic compound used in the present invention can be obtained with high efficiency, the method of utilizing a fluorine ion as a base catalyst is preferable. By applying this method, a thioether-type organic compound can be obtained without special purification after the reaction of the polyether compound (a1) having a glycidyl group at a terminal with the thiol compound (a2).

Various thiol compounds (a2) can be reacted with the polyether compound (a1). Examples thereof include, in addition to alkanethiols and benzenethiols, thioglycol, thioglycolic acid and esters thereof, and mercaptopropionic acid and esters thereof, which are widely used as a radical polymerization chain transfer agent and thus are easily available. Mercapto polycarboxylic acids such as thiomalic acid, thiocitric acid, and esters thereof may be reacted. Moreover, a compound having a plurality of thiol groups in a molecule, that is, alkylenedithiols such as ethanedithiol, trimethylolpropane=tris(3-mercaptopropionate), pentaerythritol=tetrakis(3 -mercaptopropionate), dipentaerythritol=hexakis(3-mercaptopropionate), and the like can also be similarly reacted and introduced. The compound obtained as a result has a plurality of thioether structures in a molecule, and thus can exhibit an affinity for the copper-based nanoparticle in a plurality of regions.

As a thiol compound (Q) used to obtain a high-molecular-weight compound having a structure represented by any of General Formulae (1) to (3) in a molecule, a thiol compound generally used as a chain transfer agent can be used. Specific examples thereof include thioglycol, 2-mercaptopropanol, 3-mercaptopropanol, 8-mercaptooctanol, 2,3-dihydroxypropanethiol, 2-methoxyethanethiol, 2-ethoxyethanethiol, 2-hexyloxyethanethiol, 2-(2-ethylhexyloxy) ethanethiol, 2-benzyloxyethanethiol, 2-(4-methoxybenzyloxy) ethanethiol, 2-phenyloxyethanethiol, 2-(4-methoxyphenyloxy) ethanethiol, 2-(2,4-dimethoxyphenyloxy) ethanethiol, 6-(4-hydroxymethylphenyloxy) hexanethiol, 2-acetoxyethanethiol, 2-heptanoyloxyethanethiol, 2-octanoyloxyethanethiol, 2-octadecanoyloxyethanethiol, 2-isobutyryloxyethanethiol, 2-pivaloyloxyethanethiol, thioglycolic acid, β-mercaptopropionic acid, 7-mercaptooctanoic acid, 2-mercaptopropionic acid, 2-mercaptosuccinic acid, inorganic salts, ammonium salts, and organic amine salts of these carboxylic acids, methyl thioglycolate, ethyl thioglycolate, octyl thioglycolate, ethyl β-mercaptopropionate, octyl β-mercaptopropionate, dodecyl β-mercaptopropionate, 2-(methoxyethyl) β-mercaptopropionate, 2-(methoxyethoxyethoxy) β-mercaptopropionate, 2-(4-methoxybutoxy) β-mercaptopropionate, 2-ethylhexyl thioglycolate, 2-ethylhexyl β-mercaptopropionate, 3-methoxybutoxy β-mercaptopropionate, 2-mercaptoethyl phosphate, 2-mercaptoethylphosphinic acid, 2-mercaptopropylphosphate, 2-mercaptopropylphosphinic acid, ω-mercaptoethoxyethyl phosphate, ω-mercaptopropyloxypropyl phosphate, 2-mercaptoethyl dimethyl phosphate, dimethyl 2-mercaptoethyl phosphinate, 2-mercaptoethyl diethyl phosphate, 2-mercaptopropyl diethyl phosphate, 2-mercaptoethyl diisopropyl phosphate, 2-mercaptoethyl diisobutyl phosphate, 2-mercaptoethylsulfonic acid, 2-mercaptopropylsulfonic acid, methyl 2-mercaptoethylsulfonate, ethyl 2-mercaptoethylsulfonate, methyl 2-mercaptopropylsulfonate, and ethyl 2-mercaptopropylsulfonate. Among them, thioglycol, 2,3-dihydroxypropanethiol, thioglycolic acid, β-mercaptopropionic acid, ethyl β-mercaptopropionate, and 2-ethylhexyl β-mercaptopropionate are preferable from the viewpoint of reactivity, and methyl β-mercaptopropionate is most preferable.

<Synthesis of copper fine particle composited with organic compound containing polyethylene oxide having 8 to 200 carbon atoms>

As an example for explaining the effects of the present invention, a method for producing a copper fine particle, which is composited with an organic compound containing polyethylene oxide having 8 to 200 carbon atoms, contained in the sintered body of the present invention includes a step of mixing a divalent copper ion compound with a solvent in the presence of the thioether-type organic compound and a step of reducing copper ions.

As the divalent copper ion compound, a generally available copper compound can be used, and a sulfate salt, a nitrate salt, a carboxylate salt, a carbonate salt, a chloride, an acetylacetonate complex, or the like can be used. As long as a composite with a zero-valent copper fine particle is obtained, the composite may start from a divalent compound or may be produced from a monovalent compound, and may have moisture or crystal water. In a case of being expressed excluding crystal water, specific examples thereof include $CuSO_4$, $Cu(NO_3)_2$, $Cu(OAc)_2$, $Cu(CH_3CH_2COO)_2$, $Cu(HCOO)_2$, $CuCO_3$, $CuCl_2$, $Cu_2O$, and $C_5H_7CuO_2$. Moreover, a basic salt obtained by heating the salts or exposing

the salts to a basic atmosphere, such as $Cu(OAc)_2 \cdot CuO$, $Cu(OAc)_2 \cdot 2CuO$, and $Cu_2Cl(OH)_3$, can be most suitably used. These basic salts may be prepared in a reaction system, or basic salts prepared separately outside the reaction system may be used. Furthermore, a general method of adding ammonia or an amine compound to form a complex, ensuring a solubility, and then using the complex for reduction is also applicable.

These copper ion compounds are dissolved or mixed in a medium in which the thioether-type organic compound is dissolved or dispersed in advance. A medium which can be used at this time depends on a structure of an organic compound to be used, but water, ethanol, acetone, ethylene glycol, diethylene glycol, glycerin, and mixtures thereof are suitably used, and water or a mixture of water and ethanol is particularly preferable.

The concentration of the thioether-type organic compound in various media is adjusted to 0.3% to 10% by mass from the viewpoint that control of a subsequent reduction reaction is easy.

The copper ion compound is added to the medium prepared above all at once or dividedly and mixing is performed. When a medium which is difficult to dissolve is used, a method in which the copper ion compound is dissolved in a small amount of a good solvent in advance and then added to the medium may be used.

It is preferable that a use ratio of the thioether-type organic compound and the copper ion compound to be mixed is appropriately selected according to a protection capability of the thioether-type organic compound in a reaction medium, but generally per 1 mol of the copper ion compound, 1 mmol to 30 mmol (about 2 to 60 g when a polymer having a molecular weight of 2,000 is used) of the thioether-type organic compound is prepared and 15 to 30 mmol of thereof is particularly preferably used.

Subsequently, reduction of the copper ion is performed using various reducing agents. As the reducing agent, a compound capable of promoting a reduction reaction of copper at a temperature of an ice-cooling temperature or higher and 80°C or lower, such as a hydrazine compound, hydroxylamine and a derivative thereof, a metal hydride, phosphinic acid salts, aldehydes, enediols, and hydroxyketones, is suitable since a composite with little precipitate formation is provided by the compound.

For the reduction of the copper ion, specifically, strong reducing agents such as a hydrazine hydrate, unsymmetrical dimethylhydrazine, a hydroxylamine aqueous solution, and sodium borohydride are suitable. Since these reducing agents have a capability to reduce the copper compound to zero valence, these reducing agents are suitable for producing a composite of an organic compound and a copper nanoparticle by using divalent and monovalent copper compounds as reduced copper.

Conditions suitable for the reduction reaction vary depending on a copper compound used as a raw material, a type of a reducing agent, presence or absence of complexation, a medium, and a type of a thioether-type organic compound. For example, when copper(II) acetate is reduced with sodium borohydride in an aqueous system, a zero-valent copper nanoparticle can be prepared even at about an ice-cooling temperature. On the other hand, when hydrazine is used, the reaction is slow at room temperature and a smooth reduction reaction occurs only after heating to about 60°C, and when copper acetate is reduced in an ethylene glycol/aqueous system, a reaction time of about 2 hours at 60°C is required. When the reduction reaction is completed in this manner, a reaction mixture containing a composite of an organic compound and a copper fine particle is obtained.

<Copper fine particle paste>

The sintered body in the present invention can be produced by calcining powder of the copper fine particle as it is, but from the viewpoint of dispersibility of the copper fine particle and wettability with a semiconductor device component which is an adherend, it is preferable that the powder is mixed with any solvent and used as a paste. As the concentration of the copper fine particle is higher, bonding density can be improved to suppress generation of a void or the like, but the concentration can be adjusted so that the maximum concentration of the copper fine particle is within a viscosity range suitable for coating and printing methods, and a concentration of about 50% to 95% is preferable from the viewpoint of easy supply to the adherend.

<Solvent>

As a solvent which can be used for forming the copper fine particle in the sintered body of the present invention into a paste, in addition to water, an organic solvent can also be used. As a polar organic solvent, alcohols (examples thereof include a monofunctional alcohol type such as ethanol, methanol, isopropyl alcohol, 2-ethylhexyl alcohol, hexyl alcohol, heptyl alcohol, octyl alcohol, nonyl alcohol, and decyl alcohol, a bifunctional alcohol type such as ethylene glycol, propylene glycol, diethylene glycol, triethylene glycol, propanediol, butanediol, pentanediol, hexanediol, and heptanediol, a trifunctional alcohol type such as propanetriol, butanetriol, pentanetriol, hexanetriol, and heptanetriol, a tetrafunctional alcohol type such as propanetetraol, butanetetraol, pentanetetraol, hexanetetraol, and heptanetetraol, and a pentafunctional alcohol type such as pentane pentaol and hexane pentaol. Moreover, an alcohol compound having an annular structure, such as benzenetriol, biphenylpentaol, benzenepentaol, and cyclohexanehexaol, can also be used. In addition

to the compounds, a compound having an alcohol group, such as citric acid and ascorbic acid, may be used.), aldehydes (for example, acetaldehyde and the like), or an alcohol derivative having an ether structure (for example, propylene glycol monomethyl ether, 3-methoxybutanol, propylene glycol-n-propyl ether, propylene glycol-n-butyl ether, dipropylene glycol methyl ether, diethylene glycol monoethyl ether, dipropylene glycol-n-propyl ether, dipropylene glycol-n-butyl ether, tripropylene glycol methyl ether, tripropylene glycol-n-butyl ether, polyethylene glycol having a molecular weight of 200 to 400, polypropylene glycol, and the like) can be used.

In addition, an ester-based solvent (for example, cyclohexanol acetate, dipropylene glycol dimethyl ether, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, crown ethers having a cyclic structure, and the like) can also be used.

Furthermore, a solvent having a lactam structure (for example, a β-lactam-based compound such as β-lactam, ε-caprolactam, σ-lactam, N-methyl-2-pyrrolidone, pyroglutamic acid, piracetam, and penicillin and the like) can also be used.

A non-polar organic solvent (for example, ketones such as acetone, tetrahydrofuran, N,N-dimethylformamide, toluene, hexane, cyclohexane, xylene, benzene, and the like) can also be used.

Among them, from the viewpoint of a thermal reduction action during decomposition and volatilization, an alcohol-based solvent having a boiling point of 150°C or higher and an ether-based solvent having a boiling point of 150°C or higher are preferably used.

Among them, an alcohol-based solvent having a boiling point of 150°C or higher of a bifunctional alcohol type such as ethylene glycol, propylene glycol, diethylene glycol, triethylene glycol, propanediol, butanediol, pentanediol, hexanediol, and heptanediol, and an ether-based solvent having a boiling point of 150°C or higher are preferable.

Among them, still more preferably, ethylene glycol, diethylene glycol, and polyethylene glycol having a molecular weight of 200 to 400 are preferable.

When the amount of the solvent used is 5% to 50% with respect to a metal, the solvent can be used, and the amount is more preferably 5% to 15%.

<Bonding>

A bonding test piece can be produced by applying the copper fine particle paste to a copper-65 molybdenum substrate (21 mm length × 37 mm width × 3 mm thickness) having a surface subjected to gold plating, mounting a silicon chip (5 mm square × 0.3 mm thickness) with a platinum resistor subjected to gold vapor deposition on a bonding surface, and then heating the resultant, as it is or while slightly applying pressure, to a temperature at which the copper fine particles are fused. At this time, the production can also be performed under a forming gas containing hydrogen, under a nitrogen atmosphere, or under an atmosphere of formic acid-containing nitrogen in which formic acid is contained by passing. Moreover, fusion can also be further promoted by changing a temperature profile depending on a size of a component to be bonded and a type of the solvent.

In the present invention, as an element to be bonded (component to be bonded), in addition to a metal (also including an alloy and an intermetallic compound), a ceramic (also including silicon, silicon carbide, and gallium nitride), a plastic, and a composite material thereof are exemplified regardless of the size and the thickness, but in the present invention, a metal (also including an alloy and bonding of metals), silicon, and silicon carbide are particularly preferable. Moreover, a shape of the element or the like is also not particularly limited as long as the powder or the paste can be appropriately disposed between the elements.

<Reliability evaluation for bonding site by cold-thermal shock test>

The reliability of the bonding site was evaluated by alternately exposing the bonding test piece to a low-temperature atmosphere bath (-40°C) and a high-temperature atmosphere bath (200°C) 1000 times for 5 minutes each using a gas phase thermal shock device (manufactured by ESPEC CORP., TSD-100) according to the method described in JIS C 60068-2-14 "Temperature change test method". The presence or absence of a crack and peeling was evaluated by taking out the bonding test piece every 100 cycles, 300 cycles, 600 cycles, and 1000 cycles, applying a voltage to the platinum resistor drawn on the silicon chip, and measuring increase in thermal resistance by the following expression.

$$\text{Thermal resistance Rth } (°C/W) = (T1\ (°C) - T2\ (°C))/P \qquad (W)$$

T1 = Temperature at a center on a top surface of the chip when a voltage is not applied
T2 = Temperature at the center on the top surface of the chip when a voltage is applied

$$P = \text{Applied voltage (V)} \times \text{measured current (A)}$$

<Vickers hardness of copper fine particle sintered body>

The Vickers hardness was evaluated by producing the bonding test piece separately from the sample for the reliability test, exposing a bonding cross section by polishing using a cross section polisher, and measuring a cross section of the obtained copper fine particle sintered body by an indentation method. Under the following indentation conditions, a Vickers hardness at 25°C was measured using a dynamic ultra-micro hardness tester (Shimadzu Corporation: DUH-W201) and a Vickers hardness at a high temperature was measured using a micro load tester (SAGINOMIYA SEISAKUSHO, INC.: LMH207-20).

Indenter used: Diamond-type triangular pyramid (vertical angle of 117°)
Maximum load: 1 N
Load speed: 70.6 mN/s
Holding time of maximum load: 15 s
Test temperature: 25°C and 150°C

The Vickers hardness was calculated from a depth h in which a triangular pyramid indenter penetrated into a specimen using the following expression. Shapes of the indentation introduced by the triangular pyramid indenter are analogous shapes, and the depth h of penetration of the indenter is proportional to a projected area A. When an indenter with a vertical angle of 117° is used, a relationship between the depth and the projected area follows the following expression.

$$A \text{ (projected area)} = 49 \times h \text{ (depth)}^2$$

The Vickers hardness was calculated from the A (projected area) calculated above by the following expression.

$$HV \text{ (Vickers hardness)} = 0.102 \times F \text{ [N] (test force)}/A \text{ [mm}^2\text{] (projected area)}$$

A detailed calculation method is explained in Handbook of Micro/nano Tribology (Second Edition) Edited by Bharat Bhushan, CRC Press (ISBN 0-8493-8402-8), and thus the description thereof is omitted here. Moreover, as the Vickers hardness, an average value of 10 points was used.

<Decreasing rate of Vickers hardness>

Using the Vickers hardness measured by the above method, a decreasing rate of the Vickers hardness was calculated from the following expression.

Decreasing rate (%) of Vickers hardness = Vickers hardness at 150°C (HVb)/Vickers hardness at 25°C (HVa) × 100

Examples

Hereinafter, the present invention will be described with reference to Examples. Unless otherwise specified, "%" is based on mass.

<Synthesis Example 1>

(Synthesis of copper fine particle (B-1) composited with organic compound (A-1) (thioether-type organic compound) containing polyethylene oxide, and preparation of copper fine particle aqueous dispersion (C-1) and copper fine particle paste (D-1))

As a synthesis example of a copper fine particle composited with an organic compound containing polyethylene oxide, a copper fine particle can be synthesized by the method described in Japanese Patent No. 4784847, JP-A-2013-60637, or Japanese Patent No. 5077728.

A mixture of copper(II) acetate monohydrate (manufactured by Wako Pure Chemical Industries, Ltd.) (30.0 g, 0.15 mol), methyl 3-(3-(methoxy (polyethoxy) ethoxy)-2-hydroxypropylsulfanyl) propionate (thioether-type organic compound represented by the following formula (molecular weight of 1,984)) (4.5 g):

[Chem. 2]

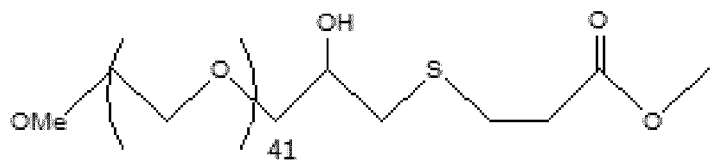

and ethylene glycol (100 mL) was heated while blowing nitrogen at a flow rate of 50 mL/min, and was degassed by aeration stirring at 125°C for 2 hours. The temperature of the mixture was returned to room temperature, and a solution in which a hydrazine hydrate (15.0 g) was diluted with 7 mL of water was slowly added dropwise thereto using a syringe pump. After about 1/4 amount of the solution was slowly added dropwise over 2 hours, the dropwise-addition was once stopped, stirring was performed for 2 hours, and the remaining amount of the solution was further added dropwise over 1 hour after checking that foaming subsided. The obtained brown solution was heated to 60°C and further stirred for 2 hours to terminate a reduction reaction, thereby obtaining a dispersion containing copper fine particles having a particle diameter of 52 nm. Subsequently, this copper fine particle dispersion was circulated in a hollow fiber ultrafiltration membrane module (HIT-1-FUS1582, 145 $cm^2$, molecular weight cutoff of 150,000) manufactured by DAICEN MEMBRANE-SYSTEMS LTD., and was circulated and purified until electrical conductivity of a filtrate from an ultrafiltration module was 100 μS/cm or less while adding distilled water, which was subjected to a deoxidation treatment using nitrogen at a flow rate of 1 L/min, in the same amount as that of the exuding filtrate. Supply of the distilled water subjected to deoxidation was stopped, and the resultant was concentrated as it was by an ultrafiltration method to obtain 28.5 g of an aqueous dispersion (C-1) containing copper fine particles coated with an organic compound (A-1) containing polyethylene oxide. The content of a nonvolatile matter of the aqueous dispersion (C-1) was 16%, and the content of a metal in the nonvolatile matter was 96.5%.

28.5 g of the aqueous dispersion (C-1) was enclosed in a 100-mL three-necked flask, and while heating at 40°C using a water bath, nitrogen was caused to flow at a flow rate of 5 ml/min under reduced pressure to completely remove water, thereby obtaining 4.5 g of copper nanoparticle composite dry powder. Next, 0.49 g of ethylene glycol subjected to nitrogen bubbling for 30 minutes was added to the obtained dry powder in a glove bag which was purged with an argon gas, and then the resultant was mixed in a mortar for 10 minutes to obtain a copper fine particle paste (D-1) having a nonvolatile matter of 90%.

<Synthesis Example 2>

(Synthesis of copper fine particle (B-2) using polyvinylpyrrolidone (A-2) as high-molecular-weight dispersant, and preparation of copper fine particle aqueous dispersion (C-2) and copper fine particle paste (D-2))

7.3 g of copper hydroxide ($Cu(OH)_2$) (manufactured by Wako Pure Chemical Corporation) was dissolved in 362 mL of aqueous ammonia having a concentration of 0.5 mol/L while blowing nitrogen at a flow rate of 50 mL/min, and ammonium acetate of 0.5 mol/L was further added to adjust pH to 10, thereby obtaining a solution containing a copper-ammine complex. On the other hand, 2.9 g of hydrazine and 3.6 g of polyvinylpyrrolidone (Wako Pure Chemical Corporation, molecular weight of 10,000) were stirred and dissolved in 725 mL of distilled water to produce a hydrazine aqueous solution. The hydrazine aqueous solution was added dropwise to the solution containing a copper-ammine complex, and a reaction was performed while stirring well to obtain a copper fine particle dispersion in which copper fine particles (B-2) having a particle diameter of about 85 nm were dispersed in an aqueous solution.

Subsequently, this copper fine particle dispersion was circulated in a hollow fiber ultrafiltration membrane module (HIT-1-FUS1582, 145 $cm^2$, molecular weight cutoff of 150,000) manufactured by DAICEN MEMBRANE-SYSTEMS LTD., and was circulated and purified until electrical conductivity of a filtrate from an ultrafiltration module was 100 μS/cm or less while adding distilled water, which was subjected to a deoxidation treatment using nitrogen at a flow rate of 1 L/min, in the same amount as that of the exuding filtrate. Supply of the distilled water subjected to deoxidation was stopped, and the resultant was concentrated as it was by an ultrafiltration method to obtain 14.9 g of an aqueous dispersion (C-2) containing copper fine particles coated with polyvinylpyrrolidone (A-2). The content of a nonvolatile matter

matter of the aqueous dispersion (C-2) was 30.1%, and the content of a metal in the nonvolatile matter was 94.6%.

A copper fine particle paste (D-2) having a nonvolatile matter of 90% was obtained by performing drying and paste formation in the same manner as in Synthesis Example 1 except that the aqueous dispersion (C-2) was used.

<Synthesis Example 3>

(Synthesis of copper fine particle (B-3) using octylamine (A-3) as low-molecular-weight dispersant, and preparation of copper fine particle dispersion (C-3) and copper fine particle paste (D-3))

A 1-L glass flask was charged with 15.7 g of copper acetate monohydrate (manufactured by Wako Pure Chemical Industries, Ltd.) and 101.6 g of octylamine (manufactured by Wako Pure Chemical Corporation) while blowing nitrogen at a flow rate of 50 mL/min, and the resultant was stirred and mixed at 40°C for 10 minutes. Next, the glass flask was put into a constant temperature water bath at 30°C, a dissolved dimethylamine borane solution was adjusted so that a liquid temperature was around 40°C and added thereto over 0.5 hours to perform a reduction treatment, and formation of a metal nucleus and growth thereof were completed to obtain a copper fine particle (B-3) coated with octylamine (A-3) and having a particle diameter of about 5 nm. 200 g of acetone was added to the solution after the reduction treatment, the resultant was allowed to stand for a while, and then a precipitate consisting of copper and an organic substance was separated and collected by filtration with a membrane filter having a pore size of 0.1 μm. Toluene was added to the collected substance, the resultant was re-dispersed, and then the filtration with the membrane filter was performed again. Subsequently, the toluene was removed under reduced pressure, and then a tetradecane solvent was added to obtain 24.0 g of a dispersion (C-3) containing copper fine particles coated with the octylamine (A-3). The content of a nonvolatile matter of the dispersion (C-3) was 40%, and the content of a metal in the nonvolatile matter was 91.2%.

A copper fine particle paste (D-3) having a nonvolatile matter of 90% was obtained by performing drying and paste formation in the same manner as in Synthesis Example 1 except that the dispersion (C-3) was used.

<Test Example 1>

(Production of bonding test pieces using copper fine particle paste (D-1) composited with organic compound (A-1) (thioether-type organic compound) containing polyethylene oxide)

The copper fine particle paste (D-1) was squeegee-applied using a mask having a thickness of 50 μm to a copper-65 molybdenum substrate (21 mm length × 37 mm width × 3 mm thickness) having a surface subjected to gold plating, a silicon chip (5 mm square × 0.3 mm thickness) with a platinum resistor subjected to gold vapor deposition was mounted on a bonding surface, and the resultant was temporarily calcined 120°C for 5 minutes and then was calcined at 200°C (Example 1), 250°C (Example 2), 300°C (Example 3), and 350°C (Example 4) for 10 minutes each under a nitrogen atmosphere to obtain bonding test pieces. Furthermore, temperature rising rates were all 43°C/min.

<Test Example 2>

(Production of bonding test pieces using copper fine particle paste (D-2) composited with polyvinylpyrrolidone (A-2) as high-molecular-weight dispersant)

Bonding test pieces were obtained by performing calcination at 200°C (Example 5), 250°C (Example 6), 300°C (Example 7), and 350°C (Example 8), respectively, in the same manner as in Test Example 1 except that the copper fine particle paste (D-2) was used.

<Test Example 3>

(Production of bonding test pieces using copper fine particle paste (D-3) composited with octylamine (A-3) as low-molecular-weight dispersant)

Bonding test pieces were obtained by performing calcination at 200°C (Example 9), 250°C (Example 10), 300°C (Example 11), and 350°C (Example 12), respectively, in the same manner as in Test Example 1 except that the copper fine particle paste (D-3) was used.

<Comparative Test Example 1>

(Production of comparative bonding test pieces using copper fine particle paste (D-1) composited with organic compound (A-1) (thioether-type organic compound) containing polyethylene oxide)

Comparative bonding test pieces were produced in the same manner as in Test Example 1 except that the copper fine particle paste (D-1) was used and the calcination temperatures were 150°C (Comparative Example 1) and 400°C (Comparative Example 2).

<Comparative Test Example 2>

(Production of comparative bonding test pieces using copper fine particle paste (D-2) composited with polyvinylpyrrolidone (A-2) as high-molecular-weight dispersant)

Comparative bonding test pieces were produced in the same manner as in Test Example 1 except that the copper fine particle paste (D-1) was used and the calcination temperatures were 150°C (Comparative Example 3) and 400°C (Comparative Example 4).

<Comparative Test Example 3>

(Production of comparative bonding test pieces using copper fine particle paste (D-3) composited with octylamine (A-3) as low-molecular-weight dispersant)

Comparative bonding test pieces were produced in the same manner as in Test Example 1 except that the copper fine particle paste (D-1) was used and the calcination temperatures were 150°C (Comparative Example 5) and 400°C (Comparative Example 6).

<Evaluation>

Evaluation results of the Vickers hardness and the reliability by the cold-thermal shock test of each of the bonding test pieces produced in Examples 1 to 12 and Comparative Examples 1 to 6 are shown in the following table.

As the results of the evaluation, regardless of the type of the surface-coated organic substance, in the copper fine particle sintered body in which the Vickers hardness at 150°C was 5% to 20% of the Vickers hardness at 25°C, the increase in thermal resistance was not observed even after 1000 cycles and favorable reliability was exhibited. On the other hand, it is considered that since the test pieces of Comparative Examples 1, 3, and 5 in which the decreasing rate of the Vickers hardness is less than 5% were sintered at a low temperature, originally, fusion did not sufficiently proceed and a crack or the like was generated at the particle interface. Furthermore, it is considered that since the fusion at the particle interface proceeded too much in the test pieces of Comparative Examples 2, 4, and 6 in which the decreasing rate of the Vickers hardness is more than 20%, the stress relaxation effect was weak, a crack was generated in the bonding element, and thus the thermal resistance was increased.

By using the sintered body of the present invention for the bonding site of the semiconductor device component, it is possible to perform bonding with high reliability, in which stress caused by a difference in thermal expansion coefficients between a semiconductor chip, such as a MOSFET and an IGBT, in which an operation at a high temperature and increase in current density are advanced in the future, and a copper or copper alloy substrate is relaxed.

[Table 1]

| | Calcination temperature (°C) | Vickers hardness at 25°C HVa | Vickers hardness at 150°C HVb | Decreasing rate of Vickers hardness HVb/HVa × 100 (%) | Thermal resistance (°C/W) after cold-thermal shock test | | | | | Reliability |
|---|---|---|---|---|---|---|---|---|---|---|
| | | | | | 0 cycles | 100 cycles | 300 cycles | 600 cycles | 1000 cycles | |
| Example 1 | 200 | 82 | 6 | 7.3 | 0.71 | 0.72 | 0.72 | 0.73 | 0.74 | Good |
| Example 2 | 250 | 103 | 8 | 7.8 | 0.72 | 0.73 | 0.74 | 0.75 | 0.76 | Good |
| Example 3 | 300 | 115 | 11 | 8.6 | 0.71 | 0.72 | 0.72 | 0.73 | 0.74 | Good |

(continued)

| | Calcination temperature (°C) | Vickers hardness at 25°C HVa | Vickers hardness at 150°C HVb | Decreasing rate of Vickers hardness HVb/HVa × 100 (%) | Thermal resistance (°C/W) after cold-thermal shock test | | | | | Reliability |
|---|---|---|---|---|---|---|---|---|---|---|
| | | | | | 0 cycles | 100 cycles | 300 cycles | 600 cycles | 1000 cycles | |
| Example 4 | 350 | 161 | 17 | 9.8 | 0.72 | 0.73 | 0.73 | 0.74 | 0.75 | Good |
| Example 5 | 200 | 78 | 6 | 7.7 | 0.71 | 0.72 | 0.73 | 0.75 | 0.75 | Good |
| Example 6 | 250 | 81 | 7 | 8.6 | 0.71 | 0.72 | 0.74 | 0.74 | 0.75 | Good |
| Example 7 | 300 | 91 | 10 | 11.0 | 0.72 | 0.75 | 0.77 | 0.79 | 0.81 | Good |
| Example 8 | 350 | 121 | 18 | 14.9 | 0.71 | 0.74 | 0.75 | 0.78 | 0.82 | Good |
| Example 9 | 200 | 78 | 5 | 6.4 | 0.73 | 0.75 | 0.76 | 0.79 | 0.81 | Good |
| Example 10 | 250 | 89 | 8 | 9.0 | 0.7 | 0.71 | 0.71 | 0.72 | 0.74 | Good |
| Example 11 | 300 | 104 | 12 | 11.5 | 0.72 | 0.74 | 0.77 | 0.8 | 0.82 | Good |
| Example 12 | 350 | 132 | 22 | 16.7 | 0.72 | 0.76 | 0.79 | 0.82 | 0.84 | Good |
| Comparative Example 1 | 150 | 56 | 2 | 3.6 | 0.77 | 0.87 | 0.91 | 1.02 | 1.32 | Poor |
| Comparative Example 2 | 400 | 198 | 47 | 23.7 | 0.71 | 0.8 | 0.88 | 0.97 | 1.22 | Poor |
| Comparative Example 3 | 150 | 60 | 2 | 3.3 | 0.82 | 1.01 | 1.13 | 1.22 | 1.43 | Poor |
| Comparative Example 4 | 400 | 167 | 49 | 29.3 | 0.67 | 0.83 | 0.94 | 1.08 | 1.23 | Poor |
| Comparative Example 5 | 150 | 86 | 2 | 2.3 | 0.78 | 0.91 | 1.14 | 1.45 | 1.81 | Poor |
| Comparative Example 6 | 400 | 174 | 43 | 24.7 | 0.68 | 0.76 | 0.9 | 1.02 | 1.37 | Poor |

## Claims

**1.** A sintered body for bonding a semiconductor device component, which is obtained by fusing copper fine particles having a primary particle diameter of 1 to 300 nm by a sintering temperature at 200°C to 350°C and composited with an organic compound containing polyethylene oxide having 8 to 200 carbon atoms,

wherein when a Vickers hardness of the sintered body at 150°C is set as Hvb and a Vickers hardness of the same sintered body at 25°C is set as Hva, a value of (Hvb/Hva) × 100 (%) is 5% or more and 20% or less, wherein the Vickers hardness was evaluated as specified in the description,
wherein the organic compound is a thioether compound according to one of Formulae (1) to (3)

$$W\text{-}(OCH_2CH_2)_n\text{-}O\text{-}CH_2\text{-}CH(OH)\text{-}CH_2\text{-}S\text{-}X \quad (1),$$

$$[W\text{-}(OCH_2CH_2)_n\text{-}O\text{-}CH_2\text{-}CH(OH)\text{-}CH_2\text{-}S\text{-}]_dY \quad (2),$$

$$[W\text{-}(OCH_2CH_2)_n\text{-}O\text{-}CH_2\text{-}CH(OH)\text{-}CH_2\text{-}S\text{-}R^a\text{-}]_tZ \quad (3),$$

wherein, in Formulae (1), (2), and (3), W is a $C_1$-$C_8$ alkyl group and n is an integer representing the repeating number of 4 to 100;
X is a $C_2$-$C_{12}$ alkyl group, an allyl group, an aryl group, an arylalkyl group, $-R^1$-OH, $-R^1$-$NHR^2$, or $-R^1$-$(COR^3)_m$,

where

$R^1$ is a $C_1$-$C_4$ saturated hydrocarbon group,
$R^2$ is a hydrogen atom, a $C_2$-$C_4$ acyl group, a $C_2$-$C_4$ alkoxycarbonyl group, or a benzyloxycarbonyl group which may have a $C_1$-$C_4$ alkyl group or a $C_1$-$C_8$ alkoxy group as a substituent on an aromatic ring,
$R^3$ is a hydroxy group, a $C_1$-$C_4$ alkyl group, or a $C_1$-$C_8$ alkoxy group, and
m is an integer of 1 to 3;

Y is a divalent to tetravalent group in which a carbon atom is directly bonded to a sulfur atom, and is a $C_1$-$C_4$ saturated hydrocarbon group or a group in which two or three $C_1$-$C_4$ saturated hydrocarbon groups are linked by -O-, -S-, or -$NHR^b$-, where $R^b$ is a $C_1$-$C_4$ saturated hydrocarbon group, and
d is an integer of 2 to 4; and,
$R^a$ is a $C_2$-$C_5$ alkylcarbonyloxy group,
Z is a divalent to hexavalent group in which a carbon atom is directly bonded to a sulfur atom, and is a $C_2$-$C_6$ saturated hydrocarbon group, an isocyanuric acid-N,N',N"-triethylene group, or a group in which two or three $C_2$-$C_6$ saturated hydrocarbon groups are linked by -O-, -S-, or -$NHR^c$- where $R^c$ is a $C_1$-$C_4$ saturated hydrocarbon group, and
t is an integer of 2 to 6,
wherein the concentration of said thioether-type organic compound is 0.3% to 10% by mass.

2. The sintered body of claim 1,
wherein the value of (Hvb/Hva) × 100 (%) is 7% or more and 10% or less.

## Patentansprüche

1. Sinterkörper zum Bonden einer Halbleiterbauelementkomponente, der erhalten wird durch Schmelzen feiner Kupferteilchen mit einem Primärteilchendurchmesser von 1 bis 300 nm bei einer Sintertemperatur von 200°C bis 350°C und mit einer organischen Verbindung verbunden ist, die Polyethylenoxid mit 8 bis 200 Kohlenstoffatomen enthält,

wobei, wenn eine Vickershärte des Sinterkörpers bei 150°C als Hvb und eine Vickershärte desselben Sinterkörpers bei 25°C als Hva festgelegt wird, ein Wert von (Hvb/Hva) x 100 (%) 5% oder mehr und 20% oder weniger beträgt,
wobei die Vickershärte wie in der Beschreibung angegeben bewertet wurde,
wobei die organische Verbindung eine Thioetherverbindung gemäß einer der Formeln (1) bis (3) ist

$$W\text{-} (OCH_2CH_2)_n\text{-}O\text{-}CH_2\text{-}CH(OH)\text{-}CH_2\text{-}S\text{-}X \qquad (1),$$

$$[W\text{-} (OCH_2CH_2)_n\text{-}O\text{-}CH_2\text{-}CH(OH)\text{-}CH_2\text{-}S\text{-}]_dY \qquad (2),$$

$$[W\text{-} (OCH_2CH_2)_n\text{-}O\text{-}CH_2\text{-}CH(OH)\text{-}CH_2\text{-}S\text{-}R^a\text{-}]_tZ \qquad (3),$$

wobei in den Formeln (1), (2) und (3) W eine $C_1$-$C_8$ Alkylgruppe ist und n eine ganze Zahl ist, die die sich wiederholende Zahl von 4 bis 100 darstellt;
X eine $C_2$-$C_{12}$ Alkylgruppe, eine Allylgruppe, eine Arylgruppe, eine Arylalkylgruppe, -$R^1$-OH, -$R^1$-$NHR^2$, oder -$R^1$- $(COR^3)_m$ ist, wobei gilt:

$R^1$ ist eine gesättigte $C_1$-$C_4$ Kohlenwasserstoffgruppe,
$R^2$ ist ein Wasserstoffatom, eine $C_2$-$C_4$ Acylgruppe, eine $C_2$-$C_4$ Alkoxycarbonylgruppe oder eine Benzyloxycarbonylgruppe, die eine $C_1$-$C_4$ Alkylgruppe oder eine $C_1$-$C_8$ Alkoxygruppe als Substituent an einem aromatischen Ring haben kann,
$R^3$ ist eine Hydroxygruppe, eine $C_1$-$C_4$ Alkylgruppe oder eine $C_1$-$C_8$ Alkoxygruppe, und
m ist eine ganze Zahl von 1 bis 3;

Y eine zwei- bis vierwertige Gruppe ist, in der ein Kohlenstoffatom direkt an ein Schwefelatom gebunden ist, und eine gesättigte $C_1$-$C_4$ Kohlenwasserstoffgruppe oder eine Gruppe ist, in der zwei oder drei gesättigte $C_1$-$C_4$ Kohlenwasserstoffgruppen durch -O-, -S- oder -$NHR^b$-verbunden sind, wobei $R^b$ eine gesättigte $C_1$-$C_4$ Kohlenwasserstoffgruppe ist, und

d eine ganze Zahl von 2 bis 4 ist; und,
$R^a$ eine $C_2$-$C_5$ Alkylcarbonyloxygruppe ist,
Z eine zweiwertige bis sechswertige Gruppe ist, in der ein Kohlenstoffatom direkt an ein Schwefelatom gebunden ist, und eine gesättigte $C_2$-$C_6$ Kohlenwasserstoffgruppe, eine Isocyanursäure-N,N',N''-Triethylengruppe oder eine Gruppe ist, in der zwei oder drei gesättigte $C_2$-$C_6$ Kohlenwasserstoffgruppen durch -O-, -S- oder -$NHR^c$-verbunden sind, wobei $R^c$ eine gesättigte $C_1$-$C_4$ Kohlenwasserstoffgruppe ist, und
t eine ganze Zahl von 2 bis 6 ist,
wobei die Konzentration der organischen Verbindung vom Thioether-Typ 0,3 bis 10 Massenprozent beträgt.

2. Sinterkörper nach Anspruch 1,
wobei der Wert von (Hvb/Hva) × 100 (%) 7 % oder mehr und 10 % oder weniger beträgt.

## Revendications

1. Corps fritté pour le collage d'un composant de dispositif semi-conducteur, obtenu par fusion de fines particules de cuivre d'un diamètre primaire de 1 à 300 nm à une température de frittage de 200°C à 350°C et composé avec un composé organique contenant de l'oxyde de polyéthylène ayant de 8 à 200 atomes de carbone,

dans lequel, lorsque la dureté Vickers du corps fritté à 150°C est fixée à Hvb et la dureté Vickers du même corps fritté à 25°C est fixée à Hva, une valeur de (Hvb/Hva) × 100 (%) est supérieure ou égale à 5 % et inférieure ou égale à 20 %,
dans lequel la dureté Vickers a été évaluée comme indiqué dans la description,
dans lequel le composé organique est un composé thioéther selon l'une des formules (1) à (3)

$$W\text{-}(OCH_2CH_2)_n\text{-}O\text{-}CH_2\text{-}CH(OH)\text{-}CH_2\text{-}S\text{-}X \quad (1),$$

$$[W\text{-}(OCH_2CH_2)_n\text{-}O\text{-}CH_2\text{-}CH(OH)\text{-}CH_2\text{-}S\text{-}]_dY \quad (2),$$

$$[W\text{-}(OCH_2CH_2)_n\text{-}O\text{-}CH_2\text{-}CH(OH)\text{-}CH_2\text{-}S\text{-}R^a\text{-}]_tZ \quad (3),$$

où, dans les formules (1), (2) et (3), W est un groupe alkyle en $C_1$-$C_8$ et n est un nombre entier représentant le nombre répétitif de 4 à 100 ;
X est un groupe alkyle en $C_2$-$C_{12}$, un groupe allyle, un groupe aryle, un groupe arylalkyle, -$R^1$-OH, -$R^1$-$NHR^2$, ou -$R^1$-$(COR^3)_m$, où

$R^1$ est un groupe d'hydrocarbures saturés en $C_1$-$C_4$,
$R^2$ est un atome d'hydrogène, un groupe acyle en $C_2$-$C_4$, un groupe alcoxycarbonyle en $C_2$-$C_4$ ou un groupe benzyloxycarbonyle qui peut avoir un groupe alkyle en $C_1$-$C_4$ ou un groupe alcoxy en $C_1$-$C_8$ comme substituant sur un anneau aromatique,
$R^3$ est un groupe hydroxy, un groupe alkyle en $C_1$-$C_4$ ou un groupe alcoxy en $C_1$-$C_8$, et
m est un nombre entier de 1 à 3 ;

Y est un groupe divalent à tétravalent dans lequel un atome de carbone est directement lié à un atome de soufre, et est un groupe d'hydrocarbures saturés en $C_1$-$C_4$ ou un groupe dans lequel deux ou trois groupes d'hydrocarbures saturés en $C_1$-$C_4$ sont liés par -O-, -S-, ou -$NHR^b$-, où $R^b$ est un groupe d'hydrocarbures saturés en $C_1$-$C_4$, et
d est un nombre entier compris entre 2 et 4 ; et,
$R^a$ est un groupe alkylcarbonyloxy en $C_2$-$C_5$,
Z est un groupe divalent à hexavalent dans lequel un atome de carbone est directement lié à un atome de soufre, et est un groupe d'hydrocarbures saturés en $C_2$-$C_6$, un groupe N,N',N''-triéthylène d'acide isocyanurique, ou un groupe dans lequel deux ou trois groupes d'hydrocarbures saturés en $C_2$-$C_6$ sont liés par - O-, -S-, ou -$NHR^c$-, où $R^c$ est un groupe d'hydrocarbures saturés en $C_1$-$C_4$, et
t est un nombre entier compris entre 2 et 6,
dans lequel la concentration dudit composé organique de type thioéther est comprise entre 0,3 % et 10 % en masse.

2. Corps fritté selon la revendication 1,

dans lequel la valeur de (Hvb/Hva) $\times$ 100 (%) est supérieure ou égale à 7 % et inférieure ou égale à 10 %.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2017188123 A1
- JP 2014167145 A
- JP 2008244242 A
- JP 2001122673 A
- JP 2017069560 A
- WO 2013133085 A
- JP 4784847 B
- JP 2013060637 A
- JP 5077728 B


### Non-patent literature cited in the description


- **GANDOUR et al.** *J. Org. Chem.,* 1983, vol. 48, 1116
- **BHARAT BHUSHAN.** Handbook of Micro/nano Tribology. CRC Press